# EUROPEAN PATENT APPLICATION

(11) **EP 4 738 437 A1**
(43) Date of publication of application: **06.05.2026**
(21) Application number: 25150724.0
(22) Date of filing: 08.01.2025
(51) Int. Cl.: H01L 23/498, H05K 1/02, H05K 3/34

(54) **SUBSTRATE PACKAGE**

(30) Priority: 04.11.2024 CN 202411557500
(71) Applicant: NXP USA, Inc., Austin, TX 78735 (US)
(72) Inventor: Liu, Huanhuan, 5656AG Eindhoven (NL); Sun, Yung-Ching, 5656AG Eindhoven (NL); Zang, Yuan, 5656AG Eindhoven (NL); Lee, Yit Meng, 5656AG Eindhoven (NL)
(74) Representative: Hardingham, Christopher Mark

(57) **Abstract**

There is provided a substrate package and method of manufacturing thereof. The substrate package comprises a carrier; a substrate having a first major surface and a second major surface, wherein the second major surface faces the carrier; a non-conductive first barrier wall extending from the second major surface towards the carrier, the first barrier wall defining first and second regions of the substrate package; and a ball grid array comprising a plurality of solder balls located between the substrate and the carrier, wherein a first subset of the solder balls is located within the first region and a second subset of the solder balls is located within the second region.

## Description

### FIELD

The present disclosure relates to a substrate package. In particular, the present disclosure relates to a substrate package comprising a ball grid array with electrical isolation and a method of fabrication thereof.

### BACKGROUND

Ball grid arrays, BGA, are a type of surface-mount packaging used in integrated circuits. To ensure safety and reliability, clearance and creepage distances need to be considered in prevention of electrical breakdowns and short circuiting, for example. Clearance distance refers to the shortest distance through air between two conductive parts or between a conductive part and the grounded surface of the equipment. It is a measure of the insulation's ability to withstand electrical stress without breaking down. Creepage distance is the shortest path along the surface of an insulating material between two conductive parts or between a conductive part and the grounded surface of the equipment. This distance helps to prevent surface leakage currents occurring due to contamination, moisture, or other environmental factors.

To comply with requirements of clearance and creepage distance, package size can become large, especially in high voltage domains. Depopulating BGA balls can help towards managing creepage, however, imbalances in distribution can cause further issues with ball level reliability.

### SUMMARY

According to a first aspect, there is provided a substrate package. The substrate package comprises a carrier; a substrate having a first major surface and a second major surface, wherein the second major surface faces the carrier; a non-conductive first barrier wall extending from the second major surface towards the carrier, the first barrier wall defining first and second regions of the substrate package; and a ball grid array comprising a plurality of solder balls located between the substrate and the carrier, wherein a first subset of the solder balls is located within the first region and a second subset of the solder balls is located within the second region.

In some embodiments, the first barrier wall may extend from the second major surface to the carrier. The carrier includes a printed circuit board, PCB, comprising a soldermask layer such that the first barrier wall extends a complete distance between the substrate and the carrier.

In some embodiments, the first barrier wall extends across a complete width of the substrate package. For example, to completely isolate the first and second regions along the width of the substrate package.

In some embodiments, the substrate package may further comprise non-conductive second and third barrier walls located at opposing ends of the substrate package to further define the first and second regions. The second and third barrier walls are located at or close to the periphery of the substrate package.

In some embodiments, the second and third barrier wall may extend from the second major surface to the carrier.

In some embodiments, the second and third barrier walls may be perpendicular to the first barrier wall.

In some embodiments, the second and third barrier walls may extend across a complete length of the substrate package. The length of the substrate package and the width of the substrate package may be similar in dimension.

In some embodiments, the first region corresponds to a first voltage domain and the second region corresponds to a second voltage domain.

In some embodiments, the first region has a larger surface area than the second region.

In some embodiments, the first barrier wall comprises a plurality of walls.

In some embodiments, the barrier wall (e.g. the first barrier wall or the first, second and third barrier walls) has a thickness that is greater than a diameter of the solder balls.

In some embodiments, the barrier wall (e.g. the first barrier wall or the first, second and third barrier walls) forms a seal between the substrate and the carrier.

In some embodiments, wherein the barrier wall (e.g. the first barrier wall or the first, second and third barrier walls) is made from an epoxy material.

According to a second aspect, there is provided a method of manufacturing a substrate package. The method comprises forming a ball grid array comprising a plurality of solder balls distributed on a substrate in a first region and a second region, wherein a first subset of the solder balls is located within the first region and a second subset of the solder balls is located within the second region; forming a non-conductive first barrier wall on the substrate between the first and second regions; and mounting the substrate comprising the solder balls and the first barrier wall to a carrier to form the substrate package.

In some embodiments, the method further comprises forming non-conductive second and third barrier walls perpendicular to the first barrier wall and located at two opposite sides of the substrate package.

In some embodiments, forming the barrier wall further comprises applying adhesive to a top surface of the barrier wall for mounting to the carrier.

In some embodiments, the barrier wall (e.g. the first barrier wall or the first, second and third barrier walls) forms a seal between the first and carriers.

In some embodiments, the method further comprises curing the barrier walls.

In some embodiments, the method comprises forming the barrier walls using a jetting machine or dispensing from a nozzle dispenser.

In some embodiments, the method comprises forming the barrier walls from an epoxy material.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures.
Figure 1A illustrates a side view of a substrate package after a first step of a method of manufacturing a substrate package;
Figure 1B illustrates a top-down view of the substrate package of Figure 1A;
Figure 2A illustrates a side view of a substrate package after a second step of a method of manufacturing a substrate package;
Figure 2B illustrates a top-down view of the substrate package of Figure 2A;
Figure 3 illustrates a side view of a substrate package after a third step of a method of manufacturing a substrate package;
Figure 4A illustrates a side view of a substrate package after a fourth step of a method of manufacturing a substrate package;
Figure 4B illustrates a top-down view of the substrate package of Figure 4A;
Figure 5 illustrates a side view of a substrate package after a fifth step of a method of manufacturing a substrate package;
Figure 6 illustrates a side view of a substrate package after a sixth step of a method of manufacturing a substrate package.

### DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

In prior art designs, large vacant areas are present in substrate packages for keeping high and low voltage domains of the substrate package apart to comply with creepage distance requirements. This results in increased package size. The present disclosure provides a mechanism for reducing the package size whilst adhering to creepage distance requirements. To do this, a barrier wall is deposited between the high and low voltage domains. This barrier wall means that the high and low voltage domains can be positioned closer together on the substrate package because of the resulting increase in creepage distance which helps to reduce package size. An increase in ball count of the BGA is also possible which increases ball level reliability, ball distribution can also be improved with more design freedom due to reduced concerns about creepage distance. Electrical breakdown capability is also increased between high and low voltage domains. A further advantage is that some stress from the BGA balls can be offloaded to the barrier wall.

In some embodiments of the present disclosure, barrier walls can also be deposited along two opposing sides of the substrate package. This helps to protect other PCB components adjacent to the high voltage domain of the package, for example. Leaving two ends of the substrate open by not depositing a barrier wall along the entire periphery of the substrate package also provides benefits, allowing gases to be released from the substrate package during BGA ball reflow (i.e. during reflow soldering).

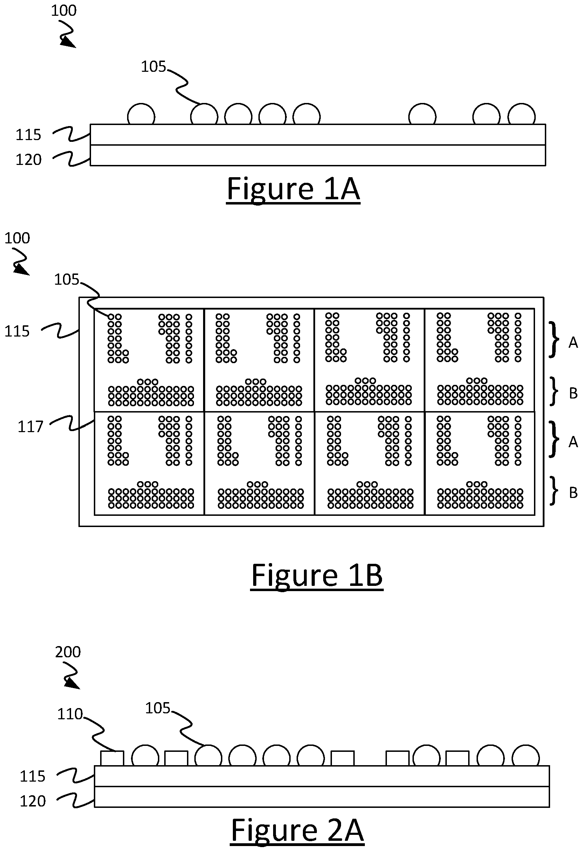

Figure 1A illustrates a side view of a substrate package after a first step 100 of a method of manufacturing a substrate package according to an embodiment of the present disclosure. The substrate package comprises a plurality of solder balls 105 arranged on and distributed about a substrate 115. The substrate 115 is mounted on a mold 120.

Not illustrated are steps prior to the solder balls 105 being mounted on the substrate 115. These steps form part of a standard Mold Array Process Ball Grid, MAP-BGA, fabrication. The steps that are not illustrated include dicing of the substrate, attaching a die to the substrate, wire bonding and molding. The skilled person is familiar with these processes in fabricating BGA substrate packages.

The substrate 115 has a first major surface and a second major surface. The mold 120 is attached to the first major surface of the substrate 115 and the solder balls 105 are adhered to the second major surface of the substrate 115.

The solder balls 105 are arranged in a ball grid array (BGA) and extend above the surface of the substrate by a distance known as standoff height. The arrangement or pattern of the solder balls 105 on the substrate 115 as illustrated in Figure 1 is an example only and should not be considered limiting. Other patterns and numbers of solder balls 105 can be designed as required, for example according to specific embodiments and applications.

Figure 1B illustrates a top-down view of the substrate package of Figure 1A. Figure 1B illustrates a plurality of identical cells, each cell comprising a BGA and separated by saw lines 117. Each cell will become a substrate package according to the present disclosure, each cell being defined by the saw lines 117.

The plurality of solder balls 105 are distributed about the surface of the substrate 115 with a first subset of the solder balls located in a first region A and a second subset of the solder balls located in a second region B. In some examples, the balls 105 are distributed in a uniform distribution, however, in other examples the balls 105 are distributed in a non-uniform way. The present disclosure allows some design freedom concerning the arrangement of the solder balls 105 on the substrate 115. Solder ball 105 distribution can vary depending on design requirements as mentioned above.

The first region A corresponds to a first voltage domain whilst the second region B corresponds to a second voltage domain. In some embodiments, the first region is a high voltage domain and the second region is a low voltage domain.

A surface area coverage of the first region A on the substrate is greater that a surface area coverage of the second region B. A distribution of the solder balls 105 depends on design requirements and can be tailored for different applications.

Figure 2A illustrates a side view of the substrate package after a second step 200 of a method of manufacturing a substrate package. In the second step of the method, one or more barrier walls 110 are dispensed on the surface of substrate 115 on the same side as the solder balls 105 and between some of the plurality of solder balls 105.

Barrier walls 110 can be deposited using a nozzle dispenser or a jetting machine. The barrier walls 110 are made of a non-conductive material such as an epoxy. In some embodiments, the barrier walls 110 are cured after they have been deposited on the substrate 115.

The barrier wall 110 may be relatively thick, for example having a thickness which is equal to or greater than a diameter of the solder balls. In other examples, the barrier wall 110 comprises a plurality of thinner walls. This can help to improve the isolation between the first and second regions. In some examples, the barrier wall 110 may comprise a plurality of barrier walls 110 (i.e. two or more barrier walls 110 deposited adjacent to one another).

Barrier wall 110 thickness, position on the substrate and count depends on user requirements and can be designed as required.

A height of the barrier walls 110 that are deposited onto the substrate 115 is lower than the height of the solder balls 105 (e.g. the standoff height) in some examples to allow for an adhesive to be applied onto an upper surface of the barrier wall 110. In other examples, the height of the barrier walls 110 is equal to or greater than the standoff height of the solder balls 105.

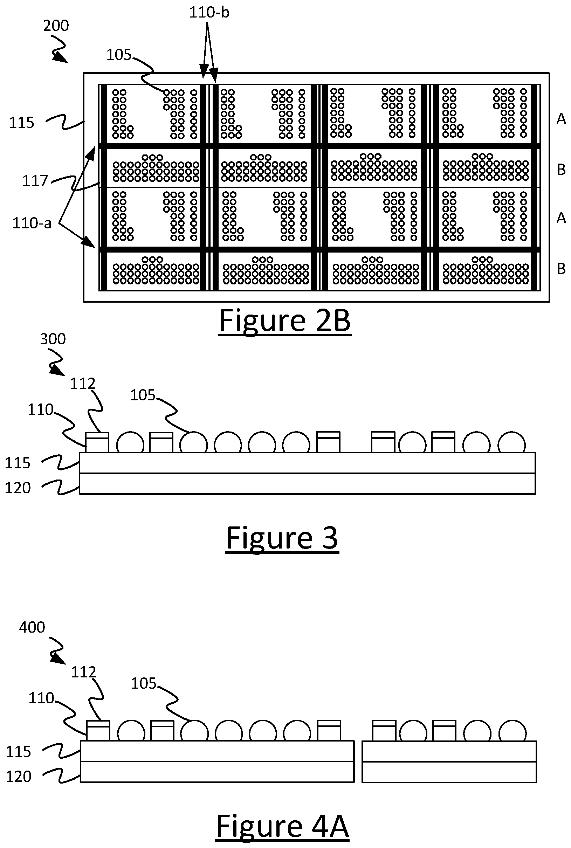

Figure 2B illustrates a top-down view of the substrate package of Figure 2A. Figure 2B illustrates the cells of Figure 1B plus the deposited barrier walls 110. The barrier walls 110 extend across the complete width or complete length of the substrate 115 to the saw lines 117.

The barrier walls 110 include a first barrier wall 110-a which extends between first and second regions A, B of the solder balls 105 in each cell so as to isolate the high and low voltage domains A, B from one another. The first barrier wall extends across the complete width of each cell. In some examples, the first barrier wall 110-a extends across the centre of each cell, whilst in other examples the first barrier wall 110-a is in an off-centre location. The location of the first barrier wall 110-a can be tailored to specific design requirements.

Second and third barrier walls 110-b extend along two opposing sides of the cells 110-b at the periphery of the cell. The second and third barrier walls 110-b extend across a complete length of each cell. These peripheral walls also help to further define the first and second regions and in use further isolate the first and second voltage domains A, B.

The shape of the barrier walls 110 is generally straight and elongate. Although in some embodiments, the first barrier wall 110 can have a crenelated shape.

Figure 3 illustrates a side view of the substrate package after a third step 300 of the method of manufacturing the substrate package. In the third step an adhesive 112 is applied to the top of the deposited barrier walls 110. The adhesive may be a glue or a Die Attach Film (DAF), soldermask material, or dry film. The adhesive 112 is selected to withstand soldering temperatures. After depositing the adhesive, the height of the barrier wall 110 including the adhesive is similar to the standoff height of the solder balls 105.

Figure 4A illustrates a side view of the substrate package after a fourth step 400 of the method of manufacturing the substrate package. The fourth step comprises package singulation. This includes sawing the substrate along the saw lines to separate the cells into individual substrates that will each form a substate package.

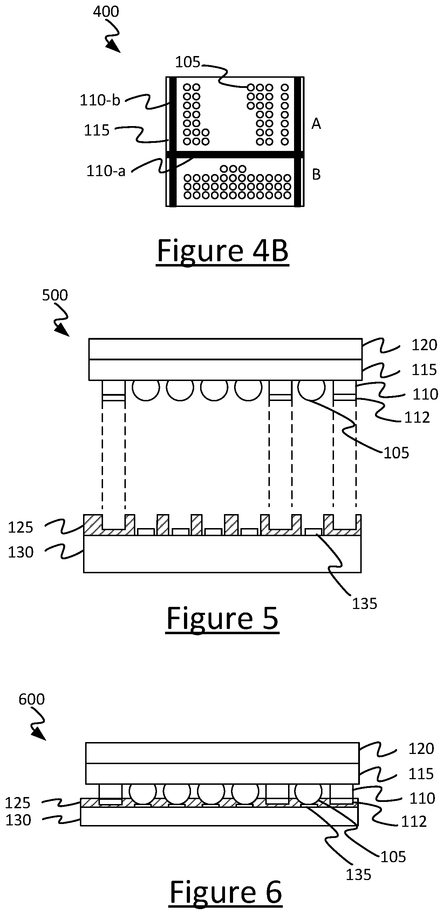

Figure 4B illustrates a top-down view of the substrate package of Figure 4A after the cells have been divided. The individual substrates comprise a plurality of solder balls 105 in the first region A and a plurality of solder balls in the second region B. The non-conductive first barrier wall 110-a extends the complete width of the substrate between the first and second regions A, B. Barrier walls 110-b extend perpendicular to the first barrier wall 110-a along two opposing sides of the substrate. No barrier wall is deposited along the other two opposing sides of the substrate such that the solder balls are not completely enclosed by barrier walls. The first and second regions A, B of the solder balls are enclosed along three sides and open along the fourth side. The openings of the substrate package at the high voltage and low voltage ends help in gas release during BGA ball reflow.

Figure 5 illustrates a side view of the substrate package during a fifth step 500 of the method of manufacturing the substrate package. Once the substrate comprising the solder balls 105, barrier walls 110, and adhesive has been singulated, it is mounted to a carrier 125, 130 to form the substrate package.

The second major surface of the substrate 115 comprising the solder balls 105 and the barrier walls 110 is faced towards the carrier 125, 130.

The carrier 125, 130 comprises a printed circuit board, PCB, 130. The PCB 130 has thereon a soldermask 125 which is patterned according to the pattern of the solder balls 105 and the barrier walls 110 of the opposing second major surface of the substrate 115. Solder pads 135 are also provided on the PCB 130 where the solder balls 105 will attach. Known techniques are used to perform soldermask patterning and solder pad depositing.

Figure 6 illustrates a side view of the substrate package after a sixth step 600 of the method of manufacturing the substrate package. Once the first substrate has been mounted on the carrier, the substrate package is assembled as illustrated in Figure 6. The barrier walls 110 form a seal between the substrate 115 and the carrier 125, 130. The adhesive 112 of the barrier wall 110 is flush with the carrier 125, 130 and the solder balls 105 are flush with solder pads 135.

The solder balls 105 and the barrier walls 110 define a distance between the second major surface of the substrate 105 and the carrier 125, 130. The barrier walls 110 extend a complete height of this distance, shielding the solder balls 105 on either side of it from each other.

Once assembled, the substrate package assembly is soldered using reflow soldering technology, for example in a reflow soldering oven.

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The present invention may be embodied in other specific forms without departing from its essential characteristics. The described embodiments are to be considered in all respects only as illustrative and not restrictive. The scope of the invention is, therefore, indicated by the appended claims rather than by this detailed description.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

## Claims

1. A substrate package comprising:
a carrier;
a substrate having a first major surface and a second major surface, wherein the second major surface faces the carrier;
a non-conductive first barrier wall extending from the second major surface towards the carrier, the first barrier wall defining first and second regions of the substrate package; and
a ball grid array comprising a plurality of solder balls located between the substrate and the carrier, wherein a first subset of the solder balls is located within the first region and a second subset of the solder balls is located within the second region.

2. The substrate package of claim 1, wherein the first barrier wall extends from the second major surface to the carrier.

3. The substrate package of claim 1 or claim 2, wherein the first barrier wall extends across a complete width of the substrate package.

4. The substrate package of any preceding claim, further comprising non-conductive second and third barrier walls located at opposing ends of the substrate package to further define the first and second regions.

5. The substrate package of claim 4, wherein the second and third barrier wall extend from the second major surface to the carrier.

6. The substrate package of claim 4 or claim 5, wherein the second and third barrier walls are perpendicular to the first barrier wall.

7. The substrate package of any of claims 4 to 6, wherein the second and third barrier walls extend across a complete length of the substrate package.

8. The substrate package of any preceding claim, wherein the first region corresponds to a first voltage domain and wherein the second region corresponds to a second voltage domain.

9. The substrate package of any preceding claim, wherein the first region has a larger surface area than the second region.

10. The substrate package of any preceding claim, wherein the first barrier wall comprises a plurality of walls.

11. The substrate package of any preceding claim, wherein the barrier wall(s) has a thickness that is greater than a diameter of the solder balls.

12. The substrate package of any preceding claim, wherein the barrier wall(s) forms a seal between the first and carriers.

13. The substrate package of any preceding claim, wherein the barrier wall(s) is made from an epoxy material.

14. A method of manufacturing a substrate package, the method comprising:
forming a ball grid array comprising a plurality of solder balls distributed on a substrate in a first region and a second region, wherein a first subset of the solder balls is located within the first region and a second subset of the solder balls is located within the second region;
forming a non-conductive first barrier wall on the substrate between the first and second regions; and
mounting the substrate comprising the solder balls and the first barrier wall to a carrier to form the substrate package.

15. The method of claim 14, further comprising forming non-conductive second and third barrier walls perpendicular to the first barrier wall and located at two opposite sides of the substrate package.
